## Europäisches Patentamt

## European Patent Office

## Office européen des brevets

(19)

(11) Veröffentlichungsnummer: **0 131 884**

**B1**

(12)

# EUROPÄISCHE PATENTSCHRIFT

(45) Veröffentlichungstag der Patentschrift:
02.11.88

(21) Anmeldenummer: 84108038.5

(22) Anmeldetag: 10.07.84

(51) Int. Cl.⁴: $C\ 04\ B\ 35/58$, $C\ 04\ B\ 35/64$ // $C23C14/26$

(54) Feuerfeste, elektrisch leitfähige Mischwerkstoffe und Verfahren zu ihrer Herstellung durch isostatisches Heisspressen.

(30) Priorität: 14.07.83 DE 3325490

(43) Veröffentlichungstag der Anmeldung:
23.01.85 Patentblatt 85/4

(45) Bekanntmachung des Hinweises auf die Patenterteilung:
02.11.88 Patentblatt 88/44

(84) Benannte Vertragsstaaten:
AT BE CH DE FR GB IT LI NL SE

(56) Entgegenhaltungen:
EP-A-0 050 875
EP-A-0 078 010
EP-A-0 084 369
DE-A-1 930 176
US-A-3 544 486
US-A-4 353 885

CHEMICAL ABSTRACTS, Band 74, nr. 12, 22. März 1971, Seite 201, Nr. 56853a, Columbus, Ohio, US; M. CLIFFORD BRICKWAY u.a.: "Development and evaluation of hot isostatically compacted boron nitride"

(73) Patentinhaber: Elektroschmelzwerk Kempten GmbH, Herzog- Wilhelm- Strasse 16, D-8000 München 2 (DE)

(72) Erfinder: Hunold, Klaus, Dr., Dipl.- Ing., Hirschdorfer Weg 3, D-8960 Kempten (DE)
Erfinder: Lipp, Alfred, Dr., Dipl.- Chem., Bürgermeister- Singer- Strasse 15, D-8939 Bad Wörishofen (DE)
Erfinder: Reinmuth, Klaus, Dr., Dipl.- Chem., An der Halde 21, D-8968 Durach (DE)

EP 0 131 884 B1

## Beschreibung

Feuerfeste, elektrisch leitfähige Mischwerkstoffe, die neben mindestens einer elektrisch leitfähigen Komponente unterschiedliche Mengen an hexagonalem Bornitrid enthalten, sind seit langem bekannt. Derartige Werkstoffe finden insbesondere für die Herstellung von Verdampferschiffchen Verwendung, die bei der Vakuumaufdampfung von Metallen im direkten Stromdurchgang erhitzt werden. Für die Verwendung als Verdampferschiffchen geeignete Mischwerkstoffe enthalten beispielsweise als elektrisch leitfähige Komponente Boride von Titan, Zirkonium, Aluminium und Chrom und/oder Carbide von Silicium, Titan und Chrom, wobei sich Boride von Titan und Zirkonium besonders bewährt haben. Der elektrische Widerstand der Verdampferschiffchen wird durch den Anteil an hexagonalem Bornitrid, als elektrisch nicht leitfähiger Komponente festgelegt, der in weitem Bereich variiert und somit jeder gewünschten Anforderung angepasst werden kann. Darüberhinaus erleichtert der Zusatz von Bornitrid aufgrund seiner Materialeigenschaften die Bearbeitbarkeit der Verdampferschiffchen (vgl. US-A-3 181 968 und US-A-3 673 118). Desgleichen sind Mischwerkstoffe bekannt, die zusätzlich Aluminiumnitrid und/oder Siliciumnitrid enthalten, wodurch die mechanische Festigkeit der Verdampferschiffchen verbessert werden soll (vgl. US-A-3 544 486 und US-A-3 813 252.

Für die Herstellung der Mischwerkstoffe werden üblicherweise homogene Pulvergemische in Graphitformen unter Anwendung von Stempeldruck heißgepresst, wobei Temperaturen von mindestens 1800°C erforderlich sind, um feste Körper mit ausreichender Dichte zu erzielen. Der Anteil an Bornitridpulver, von dem bekannt ist, daß es allein ohne Mitverwendung von Sinterhilfsmitteln nicht hoch verdichtet werden kann, wirkt auch in den Pulvergemischen sinterhemmend, sodaß unter den genannten Bedingungen des Heißpressens im allgemeinen nur Dichten von < 95 % der theoretisch möglichen Dichte erreicht werden.

Aus der GB-A-1 251 664, die der DE-A-1 930 176 entspricht, ist ein derartiges feuerfestes Material mit einem relativ hohen Anteil an Aluminiumnitrid in Form von kompakten Blöcken mit einer Dichte von mehr als 95 % TD bekannt, das durch Heißpressen bei 1800°C hergestellt werden kann. Da hierin Angaben über die Reinheit der verwendeten Ausgangspulver fehlen, ist davon auszugehen, daß die hohe Dichte durch Sauerstoffverunreinigungen erzielt worden ist, von welchen bekannt ist, daß sie als Sinterhilfsmittel wirken (vgl. US-A-3 915 900).

Mit Zusatz von Sinterhilfsmitteln können durch Heißpressen derartige Mischwerkstoffe von höherer Dichte erhalten werden. Beispiele hierfür sind Aluminium (vgl. DE-A-2 200 665 und US-A-4 008 183), Kohlenstoff (vgl. US-A-3 649 314), Boroxid (vgl. US-A-3 915 900) und Nickel (vgl. US-A-4 268 314). Durch die Mitverwendung von Sinterhilfsmitteln, die sich während des Sintervorgangs bevorzugt an den Korngrenzen ansammeln, möglicherweise unter Bildung von glasähnlichen Phasen, sind aber in den aus diesen Mischwerkstoffen hergestellten Verdampferschiffchen Schwachstellen vorprogrammiert, die dann bei der Vakuumaufdampfung von Metallen besonders leicht korrodieren. Derartige Schiffchen zeigen daher in der Preis ein unbefriedigendes Korrosionsverhalten.

Da das Heißpressen im großtechnischen Maßstab ein sehr kostenintensives Verfahren ist, werden die bekannten Mischwerkstoffe aus wirtschaftlichen Gründen in Form von grossen Blöcken hergestellt, aus welchen anschließend die einzelnen Verdampferschiffchen herausgearbeitet und mechanisch auf die gewünschten Endabmessungen bearbeitet werden. In Abhängigkeit von der Größe der einzelnen Schiffchen können dabei aus jeweils einem heißgepressten Block bis zu etwa einhundert Schiffchen hergestellt werden. Neben den oben genannten Schwierigkeiten für die Erzielung einer ausreichend hohen Verdichtung kommt bei dieser Art der Herstellung von Verdampferschiffchen erschwerend hinzu, daß im Block ein Dichtegradient vorhanden ist, das heißt, daß die Dichteverteilung innerhalb des Blockes nicht gleichmäßig ist, wodurch dessen Eigenschaften somit richtungsabhängig sind. So resultiert beispielsweise ein Widerstandsgradient über die Länge des einzelnen, daraus hergestellten Schiffchens. Diese ungleichmäßige Verteilung des Widerstandes führt bei Einsatz des Schiffchens, das heißt, beim Erhitzen im direkten Stromdurchgang zu einer ungleichmäßigen Verdampfung des Metalls und damit durch partielle Überhitzung zur Korrosion an diesen Stellen.

Der Dichtegradient im Block kommt durch den biaxialen Preßdruck zustande, der die Ausbildung eines Doppelpreßkegels zur Folge hat. Das führt zu einer ungleichmäßigen Wärmeübertragung und damit zu einer unterschiedlichen Verdichtung. Der Maximaldruck ist durch die Festigkeit des Graphits der Preßstempel begrenzt, sodaß eine bessere Dichteverteilung durch Erhöhung des Preßdrucks nicht erreicht werden kann.

Es stellt sich somit die Aufgabe, feuerfeste, elektrisch leitfähige Mischwerkstoffe insbesondere in Form von großen Blöcken mit einer Dichte von mindestens 95 % der theoretisch möglichen Dichte auf Basis von hexagonalem Bornitrid, Boriden oder Carbiden als elektrisch leitfähigem Material und gegebenenfalls Aluminiumnitrid und/oder Siliciumnitrid, zur Verfügung stellen, die nicht nur eine ausreichend hohe Dichte, sondern auch eine homogene Dichteverteilung aufweisen und die durch Verdichten von Pulvergemischen ohne Mitverwendung von Sinterhilfsmitteln auf einfache Weise hergestellt worden sind.

Die erfindungsgemäßen Mischwerkstoffe haben eine homogene Dichteverteilung innerhalb des ganzen Blockes und ein homogenes, isotropes Mikrogefüge mit richtungsunabhängigen Eigenschaften und sind unter Verwendung von praktisch sauerstoff- und metallfreien Pulvergemischen aus

10 bis 60 Gew.-% hexagonalem Bornitrid,

0 bis 60 Gew.-% Aluminiumnitrid und/oder Siliciumnitrid und

30 bis 70 Gew.-% eines elektrisch leitfähigen Materials, ausgewählt aus der Gruppe der Boride von Titan,

Zirkonium, Aluminium und Chrom und aus der Gruppe der Carbide von Silicium, Titan und Chrom,
durch isostatisches Heißpressen in einer vakuumdicht geschlossenen Hülle bei einer Temperatur von 1400°C bis 1700°C unter einem Druck von 100 bis 300 MPa im Hochdruckautoklaven unter Verwendung eines inerten Gases als Druckübertragungsmedium hergestellt worden.

Es ist zwar bekannt, daß durch das isostatische Heißpressen aufgrund der allseitigen Druckanwendung im allgemeinen eine gleichmäßigere Verdichtung und damit gleichmäßigere Eigenschaften des derart hergestellten Material erreicht werden kann.

Diese allgemeinen Aussagen sind jedoch in dieser vereinfachenden Form nicht in jedem Einzelfall zutreffend, wie insbesondere im Falle des hexagonalen Bornitrids gezeigt werden kann, wenn die Meßdaten in der Originalliteraturstelle aus dem Referat in Chemical Abstracts, vol. 74 (1971) S. 201, Nr. 56 853 a, das ist im technischen Report von M.G. Brockway et al., einer genaueren Überprüfung unterzogen werden: In diesem Report wurde beispielsweise die thermische Ausdehnung an Bornitridformkörprn gemessen, die aus einem sehr reinen Bornitridpulver (HPF-Pulver: Reinheit von B + N = 99,5 %; nominale Teilchengröße: 15 μm, vgl. S. 4, Tab. 1) durch isostatisches Heißpressen bei 1650°C (3000°F) hergestellt worden sind (vgl. S. 16, Zeile 15 - 18). In der Tabelle 9 auf Seite 17 sind die Werte für den thermischen Ausdehnungskoeffizienten in Längsrichtung (e) und in Transversalrichtung (f) mit 3,43 (e) und 1,65 (f) angegeben. Diese unterschiedlichen Werte bestätigen, daß dieses Material in beträchtlichem Ausmaß anisotrop war, das heißt, daß offensichtlich trotz der allseitigen Druckanwendung ein gerichtetes Kornwachstum nicht unterdrückt werden konnte.

Aus der Literaturstelle Chemical Abstracts, Vol. 97 (1982), S. 258, Nr. 43 096 f ist ferner ein Formkörper aus polykristallinem hexagonalem Bornitrid mit einer Dichte von über 98 % TD bekannt, der aus einem relativ grobkörnigen Bornitridpulver mit sehr geringem Sauerstoffgehalt durch isostatisches Heißpressen bei einer Temperatur von 1700°C bis 1800°C hergestellt worden ist.

In der EP-A-0 084 396, veröffentlicht am 27.7.83, wurde dann nachgewiesen, daß ein Bornitridformkörper, der aus feinkörnigem Bornitridpulver mit sehr geringem Sauerstoffgehalt durch isostatisches Heißpressen bei 1700°G hergestellt worden war, kein homogenes feinkristallines Mikrogefüge aufwies, obwohl er eine Dichte von mehr als 95 % TD hatte. Nur ein homogenes und feinkristallines Mikrogefüge garantiert aber, daß das Material tatsächlich isotrop und damit seine Eigenschaften weitgehend richtungsunabhängig sind. Im Falle von hexagonalem Bornitrid kann dieses Ziel nur durch relativ niedrige Temperaturen beim isostatischen Heißpressen erreicht werden, die 1500°C nicht überschreiten dürfen, was offensichtlich in den beiden erstgenannten Literaturstellen noch nicht erkannt wurde.

Die Kenntnis dieser entscheidenden Parameter für das hexagonale Bornitrid allein erlaubt indessen noch keinen Rückschluß auf Pulvergemische, insbesondere nicht auf solche aus Bornitrid und Komponenten, die für sich allein weit höhere Verdichtungstemperaturen erfordern, wie beispielsweise Titanborid. Anregungen dazu konnte der Fachmann in US-A-4 353 885 kaum finden, dann hierin werden für die Herstellung von Titanboridkörpern durch Heißpressen Temperaturen im Bereich zwischen 1600°C und 2700°C genannt und in dem einzigen Beispiel, in dem ein Titanboridpulver allein bei der niedrigen Temperatur von 1600°C heißgepresst wurde, hatte der so erhaltene Formkörper eine Dichte von nur 92 % TD.

Aber auch aus EP-A-0 078 010, worin Pulvergemische aus Siliciumnitrid und Siliciumcarbid ohne Sinterhilfsmittel bei Temperaturen im Bereich von 1800°C bis 2200°C isostatisch heißgepresst werden unter Erzielung von Sinterdichten von mehr als 98 % TD, konnte der Fachmann keine Anregungen für die in Frage stehenden Bornitrid enthaltenden Pulvergemische entnehmen. Denn hier wird die Lehre vermittelt, daß die jeweils optimale Temperatur für das isostatische Heißpressen neben der Feinheit insbesondere sowohl von der Reinheit des verwendeten Pulvergemisches als auch von dem Gewichtsverhältnis von Siliciumnitrid: Siliciumcarbid im Gemisch abhängig ist, das heißt, je reiner die Pulver sind und je größer der Anteil der die höhere Verdichtungstemperatur erfordernden Siliciumcarbidkomponente ist, um so höher muß die Temperatur beim isostatischen Heißpressen gewählt werden, um dichte Körper zu erhalten.

Aufgrund dieses Standes der Technik konnte der Fachmann allenfalls erwarten, daß beim isostatischen Heißpressen von sehr reinen, Bornitrid enthaltenden Pulvergemischen durch Senkung der Arbeitstemperaturen das unerwünschte Kornwachstum der Bornitridkomponente unterdrückt werden könnte, aber er mußte damit rechnen, daß dies auf Kosten einer ausreichend hohen Verdichtung des gesamten Pulvergemisches erreicht würde oder anders ausgedrückt, daß die Körper zwar isitrop, aber nicht mehr ausreichend dicht sein würden. Folgte er hingegen der gegebenen Lehre, die Arbeitstemperatur nach der die höchste Verdichtungstemperatur erfordernden Komponente, zum Beispiel dem Titanborid auszurichten, dann wären die erhaltenen Körper zwar mit Sicherheit dicht, aber nicht mehr isotrop.

Es muß demnach als überraschend bewertet werden, daß die Mischwerkstoffe von an sich bekannter Zusammensetzung, die aus sehr reinen, Bornitrid enthaltenden Pulvergemischen durch isostatisches Heißpressen bei Arbeitstemperaturen im Bereich von 1400°C bis 1700°C hergestellt werden, nicht nur isotrop, sondern auch ausreichend dicht sind. Die hohe Dichte und die homogene Dichteverteilung in Verbindung mit der hohen Reinheit des Materials garantieren die verbesserten Eigenschaften der aus diesen Mischwerkstoffen herausgeschnittenen Verdampferschiffchen, die solchen von gleicher chemischer Zusammensetzung, aber durch konventionelles Heißpressen hergestellten, insbesondere hinsichtlich ihrer längeren Lebensdauer eindeutig überlegen sind, wie durch Vergleichsversuche nachgewiesen.

Für die Herstellung der erfindungsgemäßen Mischwerkstoffe Blockform werden als Ausgangsmaterial vorteilhaft feine Pulver aus hexagonalem Bornitrid mit einer spezifischen Oberfläche im Bereich von 2 bis 30

3

m²/g, vorzugsweise im Bereich von 4 bis 16 m²/g (gemessen nach der BET-Methode), die als Maß für die Teilchengröße dient, und mit einer Reinheit von mindestens 98,0 Gew.-% verwendet, worunter zu verstehen ist, daß die Analysensumme von Bor und Stickstoff mindestens 98,0 Gew.-% beträgt. Der Gehalt an Sauerstoff in diesen Pulvern, der in Form von anhaftendem Boroxid und Boroxinitriden vorliegt, kann bis zu 1,7 Gew.-% betragen. Daneben können bis zu 0,1 Gew.-% Kohlenstoff und bis zu 0,2 Gew.-% an metallischen Verunreinigungen insgesamt, toleriert werden.

Als elektrisch leitfähiges Material werden vorteilhaft Titanborid oder Zirkonboridpulver verwendet, die ebenso wie die gegebenenfalls mitzuverwendenden Aluminiumnitrid- und/oder Siliciumnitridpulver einen möglichst geringen Sauerstoffgehalt aufweisen und praktisch frei von Metall in nicht gebundener Form sein sollen. Aufgrund ihrer Kärte werden diese Pulver vorteilhaft getrennt einer Intensivmahlung unterzogen, bis Teilchengrößen von < 50 μm erreicht sind und anschließend von den als Mahlabrieb eingebrachten Verunreinigungen befreit, bevor sie mit dem Bornitridpulver homogen vermischt werden. Dieser Mischvorgang kann trocken oder naß, beispielsweise unter Verwendung von organischen Lösungsmitteln, wie Aceton, Methanol oder Isopropanol durchgeführt werden.

Da Bornitrid enthaltende Pulvergemische üblicherweise eine sehr geringe Schüttdichte aufweisen, das heißt, beim Verdichten eine sehr große Schwindung erfahren, werden die trockenen Pulvergemische anschließend vorteilhaft zu Grünkörpern in Blockform mit offener Porosität, das heißt, mit zur Oberfläche offenen Poren vorverdichtet, bevor sie mit einer gasdichten Hülle versehen werden.

Die Formgebung kann durch übliche bekannte Maßnahmen, beispielsweise durch Gesenkpressen vorgenommen werden, wobei sich das isostatische Kaltpressen besonders bewährt hat, da hiermit eine sehr gleichmäßige hohe Vorverdichtung erreicht werden kann. Die Mitverwendung eines temporären Bindemittels ist hierbei in der Regel nicht erforderlich. Gegebenenfalls können jedoch geringe Mengen eines temporären Bindemittels, beispielsweise Campher, mitverwendet werden. Entscheidend ist hierbei nur, daß sich die Bindemittel bei Temperaturen von < 1000°C praktisch rückstandslos zersetzen. Nach der Formgebung sollte der Grünkörper in Blockform eine theoretische Dichte von mindestens 50 %, vorzugsweise von mindestens 60 % TD aufweisen.

Als gasdicht verschließbare Hüllen werden vorteilhaft vorgefertigte Hüllen aus Metall oder Metallegierungen verwendet, die bei der jeweils angewendeten Verdichtungstemperatur plastisch verformbar sein messen. Bei Temperaturen bis zu etwa 1500°C können Hüllen aus Stahlblech verwendet werden. Bei höheren Temperaturen sind indessen Hüllen aus refraktären Metallen, beispielsweise Molybdän, erforderlich. Außerdem ist es vorteilhaft, zwischen Hülle und Grünkörper eine Schicht aus hitzebeständigem Material anzubringen, um Reaktionen der Hülle mit dem Grünkörper während des isostatischen Heißpreßvorgangs zu verhindern. Als hitzebeständiges Material können beispielsweise polykristalline Aluminiumoxidfasern verwendet werden.

Nach dem Einbringen der vorverdichteten Grünkörper einschließlich der Zwischenschicht, in die mit einem Absaugstutzen versehenen Hüllen wird die Anordnung einer thermischen Behandlung durch Erhitzen auf 500° bis 1300°C unter Vakuum unterzogen, um sicher zu stellen, daß bei der heißisostatischen Verdichtung keine gasförmigen Zersetzungsprodukte aus den Bindemitteln oder Wasserdampf den Verdichtungsvorgang stören oder die Hülle beschädigen. Nach vollkommener Entgasung des Hülleninhalts wird der Absaugstutzen im Vakuum gasdicht verschweißt.

Anstelle des Einbringens der vorverdichteten Grünkörper in vorgefertigte Hüllen kann die gasdichte Hülle auch durch direkte Beschichtung auf dem Grünkörper erzeugt werden, beispielsweise durch Aufdampfen, Flamm- oder Plasmaspritzen einer Metallschicht im Vakuum oder durch Aufbringen einer glasartigen Massen, die anschließend unter Bildung der gasdichten Hülle geschmolzen oder gesintert wird. In diesem Fall ist es zweckmäßig, die Grünkörper der thermischen Behandlung fur die Entgasung zu unterziehen, bevor sie mit der gasdichten Hülle versehen werden.

Die gehüllten Körper werden in den Hochdruckautoklaven eingebracht und auf die erforderliche Verdichtungstempratur von mindestens 1400°C erhitzt. Hierbei ist es vorteilhaft, Druck und Temperatur getrennt zu regeln, das heißt, den Gasdruck erst dann zu erhöhen, wenn das Hüllmaterial anfängt, sich unter dem Druck plastisch zu verformen. Als inerte Gase für die Druckübertragung werden Helium oder Stickstoff und vorzugsweise Argon verwendet. Der angewendete Druck liegt vorzugsweise im Bereich von 100 bis 200 MPa, der unter langsamer Erhöhung bei der jeweils angewendeten Endtemperatur erreicht wird. Die jeweils optimalen Bedingungen hinsichtlich Druck, Temperatur und Haltezeit bei dieser Temperatur sind abhängig von der Zusammensetzung der Pulvermischung. Das heißt, mit Bornitridmengen ab etwa 35 Gew.-% in der Pulvermischung können Verdichtungstemperaturen im Bereich von 1400° bis 1500°C bereits ausreichend sein, während geringere Bornitridmengen in der Pulvermischung im allgemeinen Temperaturen bis zu 1700°C erfordern, um den gewünschten Verdichtungsgrad zu erreichen. Nach Erniedrigung von Druck und Temperatur werden die abgekühlten Körper aus dem Hochdruckautoklaven entnommen und die Hüllen mechanisch oder chemisch entfernt.

Die so hergestellten Blöcke aus feuerfestem, elektrisch leitfähigen Material haben in Abhängigkeit von dem angewendeten Druck, der Temperatur und der Haltezeit unter diesen Bedingungen eine theoretisch mögliche Dichte von mindestens 95 %. Aufgrund der allseitigen hohen Druckanwendung haben sie auch eine vollkommen homogene Dichteverteilung innerhalb des ganzen Blockes und ein homogenes, isotropes Mikrogefüge, sodaß ihre Eigenschaften nicht mehr richtungsabhängig, sondern in allen Richtungen gleichbleibend sind.

Aus diesen Blöcken können Verdampferschiffchen in jeder beliebigen Richtung unter bestmöglicher Raumausnutzung herausgearbeitet werden, die dann ebenfalls völlig richtungsunabhängige Eigenschaften, z. B. einen unveränderten Widerstand über die Länge des Schiffchens haben, was für ein gutes Korrosionsverhalten der Schiffchen von entscheidender Bedeutung ist.

Es ist zwar allgemein bekannt, daß durch isostatisches Heißpressen Formkörper mit bis zu 100 % der theoretisch möglichen Dichte erhalten werden können. Im Falle der Mischwerkstoffe, die für die Herstellung von Verdampferschiffchen Verwendung finden, ist jedoch eine 100 %-ige Verdichtung, das heißt, absolute Porenfreiheit nicht unbedingt erforderlich. Entscheidend ist vielmehr die homogene Dichteverteilung neben feinen und ebenfalls gleichmäßig verteilten Poren. Die Einstellung der feinverteilten Porosität durch Regelung der theoretisch möglichen Dichte im Bereich von > 95 % und < 100 % TD kann bei der Herstellung der erfindungsgemäßen Mischwerkstoffe auf einfache Weise durch Regelung der Haltezeit bei dem jeweils angewendeten Druck und der Temperatur in Abhängigkeit von der Pulverzusammensetzung erreicht werden. Im Gegensatz hierzu mußte bei den bisher angewendeten Heißpressverfahren die Einstellung der Porosität immer mehr oder weniger dem Zufall überlassen bleiben, weil bereits die Erzielung einer Dichte von 95 % TD ohne Mitverwendung von Sinterhilfsmitteln mit Schwierigkeiten verbunden war.

Die besten Ergebnisse hinsichtlich der Lebensdauer werden mit Verdampferschiffchen erzielt, die aus den erfindungsgemäßen Mischwerkstoffen mit feinverteilter Porosität hergestellt worden sind, da durch die hohe Dichte die Infiltration der Metallschmelze während des Aufdampfprozesses verhindert aber durch die vorhandene Porosität Wärmedehnungen bei der starren Einspannung der Schiffchen aufgefangen werden, während nahezu porenfreie Schiffchen unter diesen Bedingungen dazu neigen, sich zu verbiegen oder zu reißen.

Die Erfindung wird anhand der folgenden Beispiele näher erläutert:

In den Beispielen wurden als Ausgangsmaterial Pulver mit folgender Analyse verwendet:

|  |  | $TiB_2$ | BN | AlN |
|---|---|---|---|---|
| Ti | Gew.-% | 66,1 | 0,01 | 0,1 |
| Al | " | - | - | 64,7 |
| B | " | 31,2 | 43,3 | < 0,01 |
| N | " | 0,6 | 55,6 | 33,4 |
| O | " | 1,3 | 1,0 | 1,2 |
| C | " | 0,8 | 0,04 | 0,3 |
| $B_2O_3$ | " | 0,5 | 0,02 | - |
| Fe | " | 0,05 | < 0,01 | 0,2 |
| Ca | " | - | 0,02 | - |
| spez. Oberfl. $m^2/g$ | | 1,6 | 10,1 | 0,9 |
| mittl. Teilchengr. $\mu m$ | | 4,3 | 1,25 | 10 |

**Beispiel 1**

20 kg einer Pulvermischung aus 57 Gew.-% $TiB_2$ und 43 Gew.-% BN wurden in einer Kugelmühle mit Stahlkugeln 5 Stunden trocken homogenisiert. Die homogene Pulvermischung wurde in einer Polyvinylchloridhülle bei 400 MPa Flüssigkeitsdruck ohne Preßhilfsmittel kaltisostatisch zu einem zylindrischen Grünkörper von 200 mm Durchmesser und 300 mm Höhe verpreßt.

Der Grünkörper wurde in eine vorgefertigte Hülle aus 2 mm starkem Stahlblech (St 37) eingebracht. Zwischen Hülle und Grünkörper wurde eine Schicht aus polykristallinen Aluminiumoxidfasern angeordnet. Dann wurde der mit einem Absaugrohr versehene Deckel mit der Stahlhülle gasdicht verschweißt und diese anschließend unter äußerer Schutzgasspülung in einem Kammerofen auf 800° C aufgeheizt. Gleichzeitig wurde die Hülle mit einer Vakuumpumpe über das Absaugrohr evakuiert.

Nach Erreichen eines Vakuums in der Hülle von < 10⁻¹ mbar wurde das Absaugrohr gasdicht verschlossen. Der gehüllte Körper wurde in die Heißisostatpresse eingebracht und bei 1450° C unter einem Argongasdruck von 200 MPa und einer Haltezeit von 180 Minuten verdichtet. Nach dem Abkühlen wurde die Stahlhülle von dem verdichteten Körper mechanisch abgetragen.

Aus dem so hergestellten Block wurden in verschiedenen Richtungen Verdampferschiffchen mit den Abmessungen 110 mm x 20 mm x 10 mm herausgeschnitten und mit einer Vertiefung von 70 mm x 15 mm x 2 mm versehen.

Die Verdampferschiffchen hatten unabhängig von ihrer Lage im Block eine Dichte von 97,3 ± 0,2 % der theoretischen Dichte der Mischung. Der spezifische Widerstand lag bei 573 ± 10 μOhm x cm.

**Beispiel 2**

20 kg einer Pulvermischung aus 53 Gew.-% $TiB_2$, 30 Gew.-% BN und 17 Gew.-% AlN wurden wie in Beispiel 1 beschrieben, homogenisiert und kaltisostatisch zu einem zylindrischen Grünkörper von 150 mm Durchmesser

5

und 200 mm Höhe verpreßt.

Der Grunkörper wurde in eine vorgefertigte Hülle aus 0,5 mm starkem Molybdänblech eingebracht. Vor dem gasdichten Verschließen der Hülle unter Vakuum wurde diese unter vermindertem Druck auf 1000°C aufgeheizt. Der gehüllte Körper wurde in die Heißisostatpresse eingebracht und bei 1650°C unter einem Argongasdruck von 200 MPa und einer Haltezeit von 120 Minuten verdichtet. Nach dem Abkühlen wurde die Molybdänhülle von dem verdichteten Körper mechanisch abgetragen.

Aus dem so hergestellten Block wurden in verschiedenen Richtungen Verdampferschiffchen mit den gleichen Abmessungen wie in Beispiel 1 herausgeschnitten. Die Verdampferschiffchen hatten unabhängig von ihrer Lage im Block eine Dichte von 98,6 ± 0,2 % der theoretischen Dichte der Mischung. Der spezifische Widerstand lag bei 515 ± 9 μOhm x cm.

### Beispiele 3 - 6 (zum Vergleich)

Unter Verwendung der gleichen Ausgangspulver und jeweils gleicher Zusammensetzung der Pulvergemische wie in den Beispielen 1 und 2 wurden zylindrische Körper von 180 mm Durchmesser und 200 mm Höhe nach dem konventionellen Heißpressverfahren hergestellt.

In den Beispielen 5 und 6 wurden jeweils zusätzlich 2 Gew.-% Boroxid als Sinterhilfsmittel mitverwendet mit einem entsprechend verringerten Anteil an Bornitrid.

Aus den so hergestellten Blöcken wurden ebenfalls in verschiedenen Richtungen Verdampferschiffchen mit den gleichen Abmessungen wie in Beispiel 1 herausgeschnitten und die Dichte und der spezifische Widerstand bestimmt. Dabei wurden erhebliche Streuungen hinsichtlich der Dichte und insbesondere hinsichtlich des Widerstandes festgestellt. Für die folgende Prüfung wurden die jeweils dichtesten Verdampferschiffchen herangezogen.

### Prüfung der Verdampferschiffchen:

Die nach Beispiel 1 bis 6 hergestellten Verdampferschiffchen wurden unter folgenden Bedingungen für die Vakuumverdampfung von Aluminium geprüft:

Die Schiffchen wurden im direkten Stromdurchgang in einer Vakuumkammer erhitzt. Die Aluminiumzufuhr erfolgte kontinuierlich durch einen Aluminiumdraht. Die Verdampfungsrate betrug 5 g Al/Min. Nach jeweils 60 Minuten Verdampfungszeit wurde die Anlage abgeschaltet und nach dem Abkühlen wieder neu angefahren.

Unter der Lebensdauer ist die Anzahl der Cyclen in Stunden zu verstehen, nach welchen die Verdampfer durch Risse, Sprünge, Verbiegen oder Korrodieren nicht mehr weiter zu verwenden waren.

Die Ergebnisse dieser Prüfung, sowie die Zusammensetzung und Eigenschaften der geprüften Verdampfer sind in der folgenden Tabelle zusammengestellt:

### Tabelle

| Beisp. Nr. | Zusammensetzung in Gew.-% | | | | Ver- fahren | % TD* | spez. Widerstand bei Raumtemperatur in μOhm x cm | Widerstandsabfall in % nach 5 Std. Einsatz | Lebens- dauer in Std. |
|---|---|---|---|---|---|---|---|---|---|
| | TiB$_2$ | BN | AIN | B$_2$O$_3$ | | | | | |
| 1 | 57 | 43 | - | - | HIP** | 97,3 ± 0,2 | 573 ± 10 | 5 | > 20 |
| 2 | 53 | 30 | 17 | - | HIP | 98,3 ± 0,2 | 515 ± 9 | 4 | > 20 |
| 3 | 57 | 43 | - | - | HP*** | 90,7 ± 1,4 | 668 ± 39 | 15 | 8 |
| 4 | 53 | 30 | 17 | - | HP | 89,2 ± 0,9 | 632 ± 51 | 19 | 6 |
| 5 | 57 | 41 | - | 2 | HP | 96,3 ± 0,4 | 604 ± 28 | 12 | 13 |
| 6 | 53 | 28 | 17 | 2 | HP | 95,9 ± 0,6 | 590 ± 33 | 12 | 15 |

\* % TD = % Dichte bezogen auf die theoretische Dichte der Mischung
\*\* HIP = Heißisostatisch gepresst (erfindungsgemäß)
\*\*\* HP = Heißgepresst (zum Vergleich)

Unter dem Begriff "Widerstandsabfall" ist der prozentuale Abfall des Widerstandes der Verdampferschiffchen nach 5 Stunden Einsatzdauer zu verstehen. Diese Zeit wurde gewählt, weil einer der Vergleichsverdampfer bereits nach 6 Stunden ausfiel. Der Widerstandsabfall ist im allgemeinen am Anfang der Heißprüfung am größten aufgrund der Benetzung der Verdampferoberfläche durch das geschmolzene Aluminium.

Wie aus den Daten in der Tabelle ersichtlich, hatten die erfindungsgemäß hergestellten Verdampfer Nr. 1 und 2 unter den gegebenen Bedingungen eine Lebensdauer von mehr als 20 Stunden, das heißt, sie waren nach insgesamt 20 Cyclen noch weiter einsatzfähig, im Gegensatz zu den Vergleichsverdampfern Nr. 3 und 4 von gleicher Zusammensetzung.

Die Vergleichsverdampfer Nr. 5 und 6, die Unter Mitverwendung von Boroxid als Sinterhilfsmittel durch Heißpressen mit einer Dichte von > 95 % TD hergestellt worden waren, hatten zwar eine längere Lebensdauer, aber auch hier wurden 20 Stunden nicht erreicht.

Der Widerstandsabfall von > 10 % bei allen Vergleichsverdampfern deutet außerdem darauf hin, daß das geschmolzene Aluminium nicht nur die Verdampferoberfläche benetzte, sondern in die Verdampfer selbst eindringen konnte, weil diese ungleichmäßig große Poren hatten.


## Patentansprüche

1. Feuerfeste, elektrisch leitfähige Mischwerkstoffe insbesondere in Form von großen Blöcken mit einer Dichte von mindestens 95 % der theoretisch möglichen Dichte auf Basis von hexagonalem Bornitrid, Boriden oder Carbiden als elektrisch leitfähigem Material und gegebenenfalls Aluminiumnitrid und/oder Siliciumnitrid, <u>dadurch gekennzeichnet,</u> daß die Mischwerkstoffe eine homogene Dichteverteilung innerhalb des ganzen Blockes und ein homogenes, isotropes Mikrogefüge mit richtungsunabhängigen Eigenschaften haben und unter Verwendung von praktisch sauerstoff- und metallfreien Pulvergemischen aus

| 10 bis 60 Gew.-% | hexagonalem Bornitrid, |
| 0 bis 60 Gew.-% | Aluminiumnitrid und/oder Siliciumnitrid und |
| 30 bis 70 Gew.-% | eines elektrisch leitfähigen Materials, ausgewählt aus der Gruppe der Boride von Titan, Zirkonium, Aluminium und Chrom und aus der Gruppe der Carbide von Silicium, Titan und Chrom, |

durch isostatisches Heißpressen in einer vakuumdicht geschlossenen Hülle bei einer Temperatur von 1400°C bis 1700°C unter einem Druck von 100 bis 300 MPa im Hochdruckautoklaven unter Verwendung eines inerten Gases als Druckübertragungsmedium hergestellt worden sind.

2. Mischwerkstoffe nach Anspruch 1, die unter Verwendung eines Bornitridpulvers aus

| mindestens | 98,0 Gew.-% | Bor + Stickstoff |
| bis zu | 1,7 Gew.-% | Sauerstoff in Form von anhaftendem Boroxid und Boroxinitriden und |
| bis zu | 0,2 Gew.-% | metallischen Verunreinigungen insgesamt, |

mit einer spezifischen oberfläche im Bereich von 2 bis 30 m²/g, gemessen nach der BET-Methode, hergestellt worden sind.

3. Mischwerkstoffe nach Anspruch 1 und 2, die unter Verwendung von Titanborid- oder Zirkonboridpulver als elektrisch leitfähigem Material und ggf. Aluminiumnitrid- und/oder Siliciumnitridpulver mit Teilchengrößen von jeweils kleiner 50 µm, hergestellt worden sind.

4. Verfahren zur Herstellung der Mischwerkstoffe nach Anspruch 1 bis 3 durch isostatisches Heißpressen von Pulvergemischen im Hochdruckautoklaven unter Verwendung eines inerten Gases als Druckübertragungsmedium, <u>dadurch gekennzeichnet,</u> daß die Ausgangspulver homogen vermischt, die Pulvergemische zu Grünkörpern in Blockform vorverdichtet und diese vorverdichteten Körper mit einer Dichte von mindestens 50 % der theoretisch möglichen Dichte der Pulvermischung in vorgefertigte Hüllen eingesetzt oder mit einem, eine vakuumdichte Hülle bildenden Material beschichtet werden, die Hülle vakuumdicht verschlossen und die gehüllten Körper im Hochdruckautoklaven auf 1400°C bis 1700°C unter langsamer Erhöhung des Drucks auf 100 bis 300 MPa bis zur Bildung der Formkörper mit der gewünschten Dichte von > 95 % TD erhitzt, nach dem Abkühlen aus dem Hochdruckautoklaven entnommen und von den Hüllen befreit werden.

5. Verwendung der Mischwerkstoffe nach Anspruch 1 zur Herstellung von Verdampferschiffchen mit verlängerter Lebensdauer für die Vakuumaufdampfung von Metallen.


## Claims

1. Refractory, electrically conductive, mixed materials, especially in the form of large blocks, having a density of at least 95 % of the theoretically possible density based on hexagonal boron nitride, borides or carbides as electrically conductive material and optionally aluminium nitride and/or silicon nitride, characterized in that the mixed materials have a homogeneous density distribution with in the entire block and a homogeneous isotropic microstructure having non-direction-dependent properties have been manufactured using powder mixtures that are virtually free of oxygen and metal and comprise

| 10 - 60 % | by weight of hexagonal boron nitride, |
| 0 - 60 % | by weight of aluminium nitride and/or silicon nitride, and |
| 30 - 70 % | by weight of an electrically conductive material, selected from the group consisting of the borides of titanium, zirconium, aluminium and chromium and from the group consisting of the carbides of silicon, titanium and chromium, |

by means of isostatic hot pressing in a vacuum-tight closed casing at temperature of from 1400 to 1700°C and under a pressure of 100 to 300 MPa in a high-pressure autoclave, using an inert gas as pressure-transmission medium.

2. Mixed materials according to claim 1, which have been manufactured using a boron nitride powder comprising

at least 98.0 % by weight of boron + nitrogen
up to 1.7 % by weight of oxygen in the form of adherent boric oxide and boron oxynitrides, and
a total of up to 0.2 % by weight of metallic impurities,
and which have a specific surface area in the range of from 2 to 30 m²/g, measured according to the BET method.

3. Mixed materials according to claims 1 and 2, which have been manufactured using titanium boride or zirconium boride powders as the electrically conductive material and, optionally, aluminium nitride and/or silicon nitride powders each having particle sizes of less than 50 μm.

4. Process for the manufacture of the mixed materials according to claims 1 to 3 by means of isostatic hot pressing of powder mixtures in a high-pressure autoclave using an inert gas as pressure-transmission medium, characterised in that the starting powders are mixed until homogeneous, the powder mixtures are predensified to form green bodies in block form, and these predensified bodies having a density of at least 50 % of the theoretically possible density of the powder mixture are introduced into prefabricated casings or coated with a material forming a vacuum-tight casing, the casing is closed in a vacuum-tight manner and the encased bodies are heated in a high pressure autoclave at from 1400 to 1700°C while the pressure is increased slowly from 100 to 300 MPa until shaped articles having the desired density of greater than 95 % TD are formed, the articles are removed, after being cooled, from the high-pressure autoclave and are freed from the casings.

5. Use of the mixed materials according to Claim 1 for the manufacture of evaporation boats, having longer lives, for the vacuum evaporation of metals.

## Revendications

1. Matériaux réfractaires, électroconducteurs, en particulier sous forme de grands blocs ayant une densité égale à au moins 95 % de la densité théoriquement possible, à base de nitrure de bore hexagonal, de borures ou de carbures en tant que matériau électroconducteur, et éventuellement de nitrure d'aluminium et/ou de nitrure de silicium, caractérisés en ce que les matériaux mixtes ont une repartition homogène des densités à l'intérieur de la totalité du bloc et une microstructure homogène et isotrope présentant des propriétés indépendantes de l'orientation, et ont été fabriqués par utilisation de mélanges pulvérulents, pratiquement exempts d'oxygène et de métaux, constitués de

10 à 60 % en poids de nitrure de bore hexagonal,
0 à 60 % en poids de nitrure d'aluminium et/ou de nitrure de silicium, et
30 à 70 % en poids d'un matériau électroconducteur, choisi dans le groupe des borures de titane, de zirconium, d'aluminium et de chrome, et dans le groupe des carbures de silicium, de titane et de chrome, par compression isostatique à chaud dans une gaine hermétiquement fermée et étanche au vide, à une temperature de 1400 à 1700°C sous une pression de 100 a 300 MPa, en autoclave haute pression, et en utilisant un gaz inerte servant de fluide de transfert de pression.

2. Matériaux mixtes selon la revendication 1, qui ont été fabriqués en utilisant une poudre pour nitrure de bore constituée de

au moins 98,0 % en poids de bore + azote
jusqu'à 1,7 % en poids d'oxygène sous forme d'oxyde de bore adhérent et d'oxynitrures de bore, et
jusqu'à 0,2 % en poids en tout d'impuretes métalliques,
avec une aire spécifique de 2 à 30 m²/g, mesurée par la méthode BET.

3. Matériaux mixtes selon les revendications 1 et 2, qui ont été fabriqués en utilisant une poudre de borure de titane ou de borure de zirconium en tant que matériau électroconducteur, et éventuellement d'une poudre de nitrure d'aluminium et/ou de silicium, chaque poudre ayant une granulométrie inférieure à 50 μm.

4. Procédé pour la fabrication de matériaux mixtes selon les revendications 1 à 3 par compression isostatique à chaud de mélanges pulvérulents en autoclave haute pression et en utilisant un gaz inerte en tant que fluide de transfert de pression, caractérisé en ce qu'on mélange les poudres de départ d'une manière homogène, on précomprime les mélanges pulvérulents pour obtenir des comprimés sous forme de blocs, et on installe ces corps précomprimés, ayant une densité d'au moins 50 % de la densité théoriquement possible du mélange pulvérulent, dans des gaines préfabriquées, ou on les enrobe d'un matériau formant une gaine étanche au vide, on obture la gaine d'une manière étanche au vide et on chauffe les corps gainés, en autoclave haute pression, à 1400 - 1700°C tout en augmentant lentement la pression à 100 - 300 MPa jusqu'à la formation des corps façonnés ayant la densité voulue supérieure à 95 % de la densité théorique, on les prélève de l'autoclave haute pression après refroidissement et on les débarrasse des gaines.

5. Utilisation des matériaux mixtes selon la revendication 1 pour fabriquer des nacelles pour évaporation présentant une durée de vie prolongée, pour la métallisation sous vide.